Europäisches Patentamt

(19) European Patent Office

Office européen des brevets

(11) Numéro de publication: **0 143 038**
**A1**

## (12) DEMANDE DE BREVET EUROPEEN

(21) Numéro de dépôt: **84402169.1**

(22) Date de dépôt: **29.10.84**

(51) Int. Cl.⁴: **H 02 H 9/02**
**H 03 K 17/693**

(30) Priorité: **02.11.83 FR 8317403**

(43) Date de publication de la demande:
**29.05.85 Bulletin 85/22**

(84) Etats contractants désignés:
**DE GB NL**

(71) Demandeur: **COMMISSARIAT A L'ENERGIE ATOMIQUE**
**Etablissement de Caractère Scientifique Technique et**
**Industriel**
**31/33, rue de la Fédération**
**F-75015 Paris(FR)**

(72) Inventeur: **Bisotto, Sylvette**
**3 Res. Beauséjour Rue Bach Le Fontanil Cornillon**
**F-38120 Saint Egreve(FR)**

(72) Inventeur: **Blanc, Jean-Philippe**
**Clos Fleurs et Neige**
**F-38410 Saint Martin d'Uriage(FR)**

(72) Inventeur: **Bodin, Bernard**
**31, Le Plaçage**
**F-38360 Sassenage(FR)**

(72) Inventeur: **Poujois, Robert**
**Les Jaillets**
**F-38650 Sinard(FR)**

(74) Mandataire: **Mongrédien, André et al,**
**c/o BREVATOME 25, rue de Ponthieu**
**F-75008 Paris(FR)**

(54) **Dispositif de protection contre des courts-circuits dans une matrice de composants électroniques.**

(57) Dispositif de protection contre des courtcircuits dans une matrice de composants électroniques. Les composants électroniques comportent des transistors de commande (3) et une résistance en série avec la grille ou le drain du transistor de commande (3) est branchée entre cette grille ou ce drain respectivement et la ligne (1) ou la colonne (2) correspondante de la matrice. La résistance peut être réalisée par un transistor MOS à déplétion (6) ou par une liaison en silicium polycristallin dopé, dont le dopage est faible afin de réaliser ainsi une résistance de protection de grande valeur.

Le dispositif selon l'invention s'applique en particulier à une matrice de transistor de commande d'un écran d'affichage matriciel à cristal liquide.

FIG. 1

EP 0 143 038 A1

La présente invention a pour objet un dispositif de protection contre des courts-circuits dans une matrice de composants électroniques.

Elle s'applique à tout arrangement matriciel de composants électroniques et en particulier à une matrice de transistors de commande d'un écran d'affichage à cristal liquide ou électroluminescent, ou d'un détecteur optique matriciel.

Dans une matrice de composants électroniques, les défauts provoquant un court-circuit entre des lignes et des colonnes ou entre des lignes ou colonnes voisines de la matrice sont plus gênants que des coupures des interconnexions ou que le non fonctionnement d'un élément de la matrice.

Au cas où un court-circuit se produirait dans une matrice d'un imageur, il apparaitrait sur l'écran des lignes horizontales et verticales sans signal vidéo, correspondant aux lignes et aux colonnes où le court-circuit aurait lieu, ce qui dérangerait fortement l'aspect optique de l'image reproduite sur l'écran.

Un court-circuit rend donc la matrice inutilisable. Il peut être dû à un court-circuit grille-drain d'un transistor MOS, ce qui est le cas le plus fréquent ou à un court-circuit au croisement ligne-colonne. Ce dernier cas est très rare.

La présente invention a justement pour objet un dispositif de protection contre les courts-circuits permettant de remédier à cet inconvénient. En particulier, elle évite le court-circuit entre la grille et le drain d'un transistor MOS. Elle peut être utilisée en particulier dans chaque cas où un court-circuit dans la grille d'un transistor MOS risque de provoquer un court-circuit sur une ligne d'alimentation ou sur une ligne d'horloge d'une matrice d'un imageur.

B 8064.3 M/LC

De façon plus précise, l'invention a pour objet un dispositif de protection contre des courts-circuits dans une matrice active de composants électroniques comportant des transistors de commande caractérisé en ce qu'une résistance, en série avec la grille ou le drain du transistor de commande est branchée entre cette grille ou ce drain respectivement et la ligne ou la colonne correspondante de la matrice.

Selon une autre caractéristique, la résistance est réalisée par un transistor MOS à déplétion.

Selon une autre caractéristique, la liaison entre la ligne et la grille du transistor de commande est réalisée en silicium polycristallin dopé dont le dopage est faible afin de réaliser ainsi une résistance de protection de grande valeur.

D'autres avantages et caractéristiques de l'invention ressortiront de la description qui suit, donnée à titre illustratif et non limitatif, en référence aux dessins annexés dans lesquels :

- la figure 1 représente schématiquement un premier mode de réalisation du dispositif selon l'invention,

- la figure 2 représente schématiquement un deuxième mode de réalisation du dispositif selon l'invention.

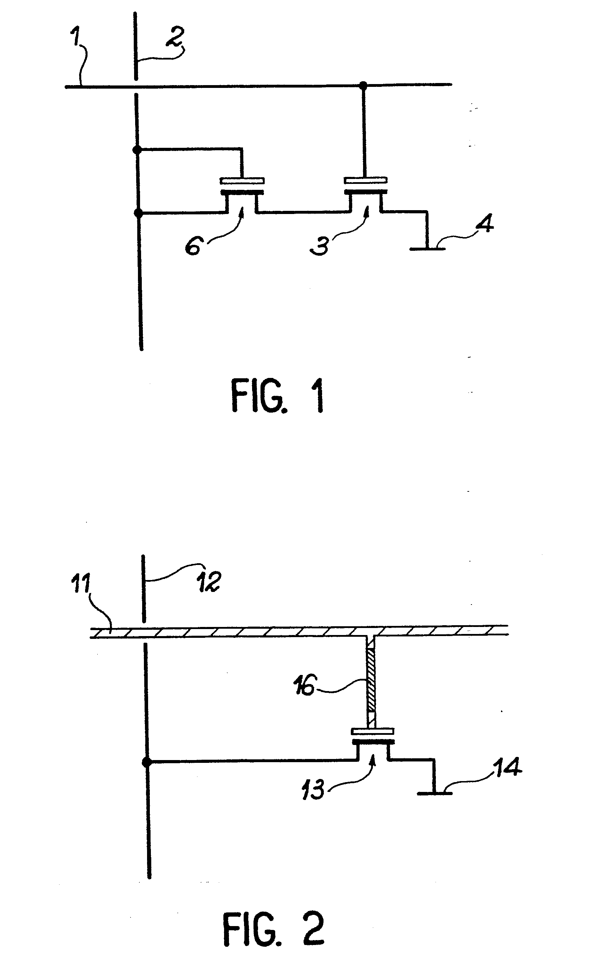

Sur la figure 1, on a représenté une ligne 1 et une colonne 2 conductrices servant à véhiculer les signaux de commande des composants électroniques d'une matrice. Dans ce cas précis, le composant électronique est un transistor MOS de commande 3 d'un élément de l'écran d'affichage à cristal liquide. La référence 4 désigne l'électrode du point d'affichage élémentaire.

Entre la colonne 2 et le drain du transistor de commande 3 un transistor MOS à déplétion 6 est branché en série. Sa grille et son drain sont connectés à la colonne, sa source est connectée au drain du transistor de commande 3.

Le transistor à déplétion 6 a une tension de seuil telle que sa résistance "ON" est satisfaisante pour une différence de potentiel égale à zéro entre sa grille et sa source. Donc un court-circuit qui s'effectue entre la grille et le drain du transistor de commande 3 ne peut pas se propager sur le croisement ligne-colonne.

Sur la figure 2, on a représenté un deuxième mode de réalisation d'une protection contre les courts-circuits.

Le transistor MOS 13 commande une électrode d'un point élémentaire d'affichage 14 d'un écran à cristal liquide. Le drain du transistor MOS 13 est connecté à la colonne 12, la grille avec la ligne 11 par une interconnexion 16 grille-ligne qui est réalisée en silicium polycristallin dopé dont le dopage est affaibli par rapport au dopage de la ligne 11. On a donc réalisé une résistance qui peut être de grande valeur (de 1 à 10 MΩ) et qui est suffisante pour éviter les courts-circuits sans trop limiter la vitesse de fonctionnement du transistor MOS 13.

Ici la ligne 11 est réalisée en silicium polycristallin dopé mais elle peut être aussi réalisée en aluminium, comme la colonne 12.

Ces résistances de protection peuvent être utilisées dans tous les cas où un court-circuit dans la grille d'un transistor MOS risque de provoquer un court-circuit sur une ligne d'alimentation ou sur une ligne d'horloge d'une matrice des composants électroniques.

## REVENDICATIONS

1. Dispositif de protection contre des courts-circuits dans une matrice active de composants électroniques comportant des transistors de commande (3, 13) caractérisé en ce qu'une résistance en série (16) avec la grille ou le drain du transistor de commande (3, 13) est branchée entre cette grille ou ce drain respectivement et la ligne (1, 11) ou la colonne (2, 12) correspondante de la matrice.

2. Dispositif selon la revendication 1, caractérisé en ce que la résistance est réalisée par un transistor MOS à déplétion (6).

3. Dispositif selon la revendication 1, caractérisé en ce que la liaison entre la ligne et la grille du transistor de commande (13) est réalisée en silicium polycristallin dopé, dont le dopage est faible afin de réaliser ainsi une résistance (16) de protection de grande valeur.

FIG. 1

FIG. 2

**0143038**
Numéro de la demande

Office européen
des brevets

**RAPPORT DE RECHERCHE EUROPEENNE**

EP  84 40 2169

## DOCUMENTS CONSIDERES COMME PERTINENTS

| Catégorie | Citation du document avec indication. en cas de besoin. des parties pertinentes | Revendication concernée | CLASSEMENT DE LA DEMANDE (Int Cl.4) |
|---|---|---|---|
| A | DE-A-2 123 395  (TEKADE) <br> * Figures 1,5; page 4, ligne 15 - page 5, ligne 2 * | 1 | H 02 H    9/02 <br> H 03 K   17/693 |
| | --- | | |
| A | US-A-4 200 898  (THOMPSON) <br> * Figure 2; Abrégé * | 1 | |
| | ----- | | |

**DOMAINES TECHNIQUES RECHERCHES (Int. Cl.4)**

H 02 H
H 03 K
H 01 L

Le présent rapport de recherche a été établi pour toutes les revendications

| Lieu de la recherche <br> LA HAYE | Date d'achèvement de la recherche <br> 03-01-1985 | Examinateur <br> KOLBE W.H. |
|---|---|---|